# EUROPEAN PATENT APPLICATION

(11) **EP 1 801 600 A1**
(43) Date of publication of application: **27.06.2007**
(21) Application number: 05112975.7
(22) Date of filing: 23.12.2005
(51) Int. Cl.: G01R 29/14, G01D 5/24, G01H 17/00

(54) **Electrostatic sensor**

(71) Applicant: The European Community, represented by the European Commission, 1049 Brussels (BE)
(72) Inventor: Coutsomitros, Constantin, 21020, RANCO (IT); Korn, Christophe, 2440, GEEL (BE)
(74) Representative: Schmitt, Armand

(57) **Abstract**

An electrostatic sensor (10) generally comprises a sensor head (12) with at least one passive sensing electrode (14) responsive to an electric field and a high-impedance amplification stage associated with the sensing electrode (14). The high-impedance amplification stage is configured for outputting at least one output signal in response to an electric signal induced on the at least one sensing electrode by the electric field. The sensor head (12) further comprises a screen (16) of electrically insulating material, which is associated with the at least one sensing electrode. In an operational mode of the electrostatic sensor, the screen is electrically charged.

## Description

### Technical field

The present invention generally relates to the sensing of electric fields in the regime commonly referred to as "electrostatics" and in particular to an extremely sensitive electrostatic sensor.

### Background Art

The field of electrostatics, which concerns itself with electrical charges, potentials and forces, has first been studied in the 18^{th} and 19^{th} centuries. The most important instruments for exploring the world of electrostatics are electroscope or electrometer.

An electroscope usually comprises two thin gold leaves suspended from an electrical conductor inside an electrically insulating container. The electrical conductor is connected to an electrode outside the container. The electroscope indicates the presence of a charged body by the gold leaves standing apart at a certain angle. A charged body, which is brought close to or in contact with the electrode induces or transfers a like electric charge to each gold leaf, which in consequence repel each other.

An electrometer is usually an elaborate variant of a voltmeter with a very high input impedance (up to the order of 10¹⁵ Ohms). Such an electrometer can be used for remotely sensing any electrically charged object. It is not possible, however, to sense uncharged, i.e. electrically neutral bodies.

### Object of the invention

It is an object of the present invention to provide an electrostatic sensor capable of remotely sensing uncharged electrically conductive bodies. This object is achieved by an electrostatic sensor according to claim 1.

### General Description of the Invention

An electrostatic sensor generally comprises a sensor head with at least one passive sensing electrode responsive to an electric field and a high-impedance amplification stage associated with the sensing electrode. The high-impedance amplification stage is configured for outputting at least one output signal in response to an electric signal induced on the at least one sensing electrode by the electric field. According to an important aspect of the invention, the sensor head comprises a screen of electrically insulating material, which is associated with the at least one sensing electrode. In an operational mode of the electrostatic sensor, the screen is electrically charged. It has been surprisingly found that by the presence of the charged screen, the electrostatic sensor can be used to detect conductive, uncharged objects, which are in movement with respect to the sensor head or the sensing electrode. The charged screen electrostatically induces a separation of positive and negative charges in the conductive object, which has an effect on the surrounding electric field. When the sensor head is moved with respect to the conductive object, this effect can be detected. As shall be noticed, the sensor is passive in the sense that it does not include an excitation electrode, which applies an alternative electromagnetic field to be sensed by a receiving electrode.

It will be appreciated that the electrostatic sensor can be used for detecting an electrically uncharged conductive body at rest in a target region. To this effect, the sensor head is moved with respect to the target region and spatial variations of the electric field are sensed so as to locate the electrically uncharged conductive body, e.g. a metal landmine. Similarly, the electrostatic sensor can be used for detecting an electrically uncharged conductive body moving in a target region. In this case, one preferably keeps the sensor head at rest with respect to the target region and senses the spatial variations of the electric field so as to locate the electrically uncharged conductive body.

The impedance and the amplification factor of the electrostatic sensor can be chosen such that currents in the sensing electrode of the order of 10⁻¹⁷ Amperes can be measured. Preferably, the gain and/or the input impedance can be adjusted, e.g. by means of a rotary-type switch. As shall be noted, the sensitivity of the system also increases if the electric charge of the screen of electrically insulating material increases.

Preferably, the electrostatic sensor comprises a grounded reference electrode connected to the amplification stage.

The sensing electrode can have a variety of forms, e.g. rectangular, circular, cylindrical, etc. Preferably, however, the sensing electrode comprises a stick electrode or a plate electrode. The material of the sensing electrodes may be any good conductor, e.g. copper, gold, silver, aluminium, nickel, etc. It will be appreciated that the sensor's sensitivity increases with the size of the sensing electrode. In the case of a stick electrode, the insulating screen advantageously comprises a tubular screen arranged coaxially around the electrode, e.g. a plastic drinking-straw. It will be appreciated that the charged layer can be movably or removably mounted on the sensor head. The electrostatic sensor can hence easily be used in two different modes: first, for the extremely sensitive detection of uncharged conductors and second, for the extremely sensitive detection of charged objects.

According to a preferred embodiment of the invention, the electrostatic sensor further includes a processing unit operationally connected to the amplification stage for analysing the sensed electric field. In particular, the amplification stage or the processing unit can comprise an analog-to-digital converter unit for digitising the amplified signals.

According to a further embodiment of the invention, the electrostatic sensor comprises a plurality of passive sensing electrodes. The amplification stage is configured so as to output a plurality of output signals, each one of these output signals being in response to an electric signal induced on a respective sensing electrode. Such an electrostatic sensor can, for instance, be used for tracking the movement of an uncharged, conductive object. The movement of the conductive object can be determined by triangulation methods. The distance from the object to each electrode can be obtained by comparing the amplitudes of the signals induced in the electrodes. The number of electrodes required for following the movement may depend on the degrees of freedom of the object in movement.

According to yet another embodiment of the invention, the sensing electrodes are arranged in a matrix-like configuration, wherein the distance between the electrodes is substantially smaller than the objects to be detected/and or imaged. With such a sensor, a two-dimensional image of an electric field can be produced. Advantageously, it includes a processing unit connected to the amplification stage for producing the 2D-image of the electric field and/or means for displaying information related to said electric field. In some embodiments of the invention, the matrix is rectangular but it could also be hexagonal.

An application of an electrostatic sensor is, for instance, the contactless sensing of vibrations. By means of a sensing electrode matrix, two-dimensional images of vibrational modes can be contactlessly obtained.

It will furthermore be highly appreciated that the electrostatic sensor can be used for recording an electroencephalogram or an electrocardiogram. This is done without applying electrodes on the patient's skin, which constitutes a considerable advantage over the traditional technique. The sensor head can be configured as a hood with the sensing electrodes distributed over its inner surface. Consequently, a map of the patient's cerebral activity can be provided.

Another useful application of the electrostatic sensor is the contactless detection of an electric signal in a cable or wire. As will be appreciated, even a shielded cable or wire can be eavesdropped with a sufficiently sensitive electrostatic sensor.

### Brief Description of the Drawings

Preferred embodiments of the invention will now be described, by way of example, with reference to the accompanying drawings in which:
- Fig. 1:: is a perspective view of a setup for the detection of the movement of an uncharged conductive object;
- Fig. 2:: is a perspective view of a setup for the detection of a movement in three dimensions of an uncharged conductive object;

- Fig. 3:: is an illustration of the use of an electrostatic sensor for recording an electroencephalogram;
- Fig. 4:: is a perspective view of an experimental setup with an electrostatic sensor adapted for spatially resolved detection of uncharged conductive objects;
- Fig. 5:: is a perspective view of an experimental setup with an alternative electrostatic sensor adapted for spatially resolved detection of unconductive objects;
- Fig. 6:: is a simplified block diagram of the electrical circuits of the electrostatic sensors of Fig. 4 and 5;
- Fig. 7:: is a block diagram illustrating the contactless detection of signals in a shielded cable.
- Fig. 8:: is a perspective view of an alternative embodiment of a sensor head for an electrostatic sensor.

### Description of Preferred Embodiments

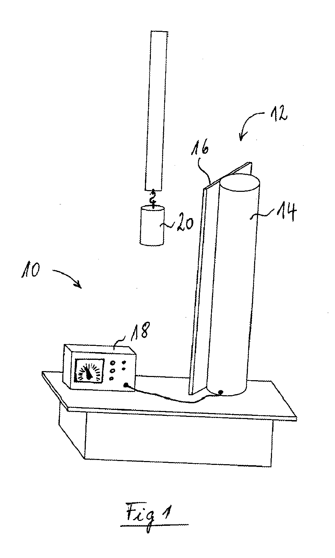

Fig. 1 shows an experimental setup illustrating the detection of a movement of a conductive object by means of an electrostatic sensor 10. The electrostatic sensor comprises a sensor head 12 with a passive cylindrical metal sensing electrode 14, which is at rest with respect to a reference system (corresponding in this case to the lab room). The sensor head 12 also comprises an electrically charged plastic screen 16, which is tangent to the cylindrical sensing electrode 14. In this case, the plastic screen 16 is arranged between the object to be sensed and the sensing electrode 14. The sensing electrode 14 is electrically connected to an electrometer 18 integrating a high-impedance amplification stage, preferably with variable amplification. Alternatively, the sensing electrode can also be connected to a computer, via the amplification stage and an analog-to-digital converter.

A metal body 20 is suspended from the lab room ceiling and may freely swing. When the metal body 20 moves with respect to the electrode 14, small currents are electrostatically induced in the latter, which can be detected by the electrometer 18. Experiments under lab conditions have shown that currents of 10⁻¹⁷ Amperes can be measured. The sensitivity of the system is extraordinarily high and the achieved precision is comparable to interferometric measurement techniques, with the distance from the electrode 14 and the metal body 20 up to three metres.

The electrostatic sensor of Fig. 1 can also be used for detecting vibrations of any conductive structure, e.g. an engine or a wall in proximity of an engine. In contrast to acceleration sensors, the electrostatic sensor needs not being in contact with the object that vibrates. This constitutes a considerable advantage, as any additional mass on the object alters its resonance frequencies changes the measurement.

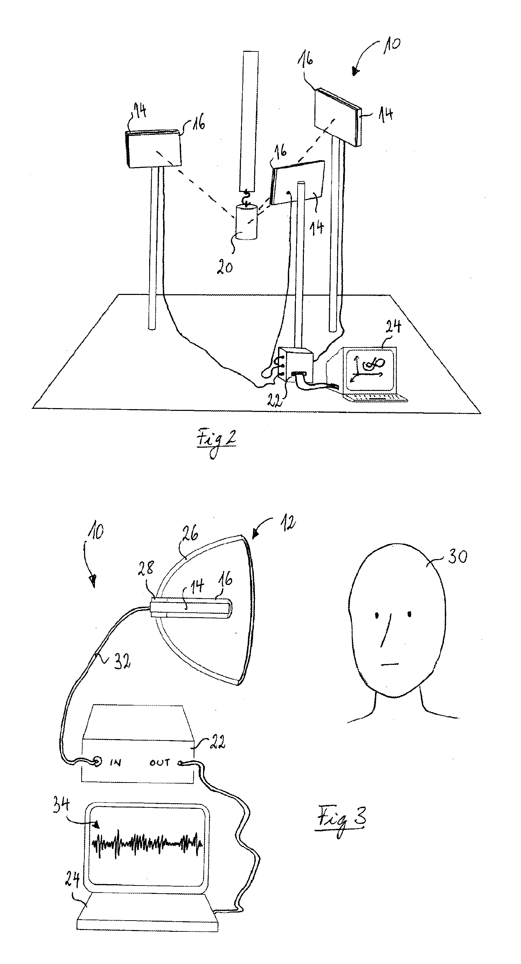

Fig. 2 shows another experimental setup illustrating the tracking of an object in three dimensions. The electrostatic sensor 10 comprises in this case three passive metal-plate sensing electrodes 14, each one covered with a plastic screen 16. The sensing electrodes are electrically connected to a high-impedance amplification stage 22, which converts the electrical currents electrostatically induced on in the electrodes 14 to output signals. The output signals are passed on to a computer 24, which is equipped with an analog-to-digital converter. The computer 24 analyses the output signals of the amplification stage 22 and determines the position of the metal body 20 by triangulation, i.e. by calculating the distance of the metal body to each sensing electrode 14. The movement of the metal body is displayed in real time on the computer screen and stored in memory for later analysis.

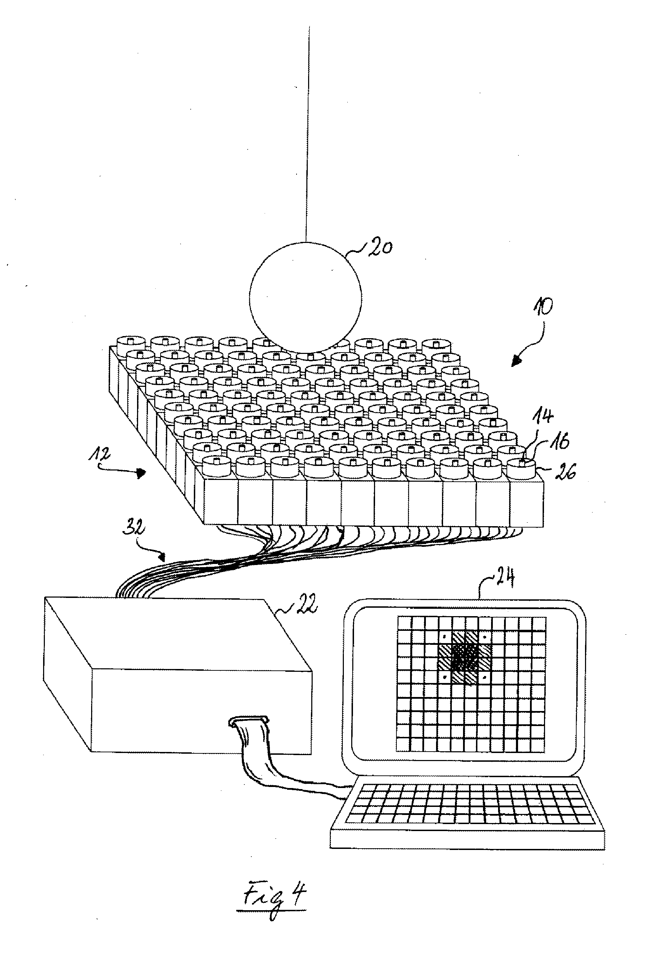

Fig. 3 illustrates the use of an electrostatic sensor 10 for recording an electroencephalogram. The sensor head 12 is shown in a cross-sectional view. The sensor head 12 comprises a stick-like sensing electrode 14, which is arranged on the axis of a grounded paraboloidal reference electrode 26. The sensing electrode 14 is fixed to the reference electrode 26 with an insulating mounting 28. The sensing electrode 14 is covered with a tubular plastic screen 16, which has been electrically charged prior to the measurement. The sensor head 12 is oriented towards a patient's head 30. It should be noted that other sensor head configurations, especially regarding the form of the sensing electrode or the reference electrode can be used.

The sensing electrode 14 is connected to a high-impedance amplification stage 22 with a shielded cable 32. The amplification stage amplifies the signals received on the sensing electrode and outputs corresponding output signals. A computer 24, which includes an analog-to-digital converter, records and analyses the output signals of the amplification unit 22 and visualises the recorded data 34. The electrostatic sensor remotely senses the surface electric potentials caused by the currents flowing in the patient's head.

The setup illustrated in Fig. 3 allows the recording of a patient's electroencephalogram but it will be appreciated that the sensor head could also be directed to other regions of the patient's body, e.g. the chest for recording an electrocardiogram. A plurality of sensing electrodes may also be used. The measurement method does not require contacting the patient with paste-on electrodes. It shall be emphasised that the sensitivity of the system is greatly enhanced by the screen of electrically charged, insulating material. Furthermore, if the electric charge of the screen increases, the sensitivity of the system increases. By increasing the electric charge of the screen, one may reduce the amplification factor of the high-impedance amplification stage or increase the distance between the patient and the sensing electrode(s).

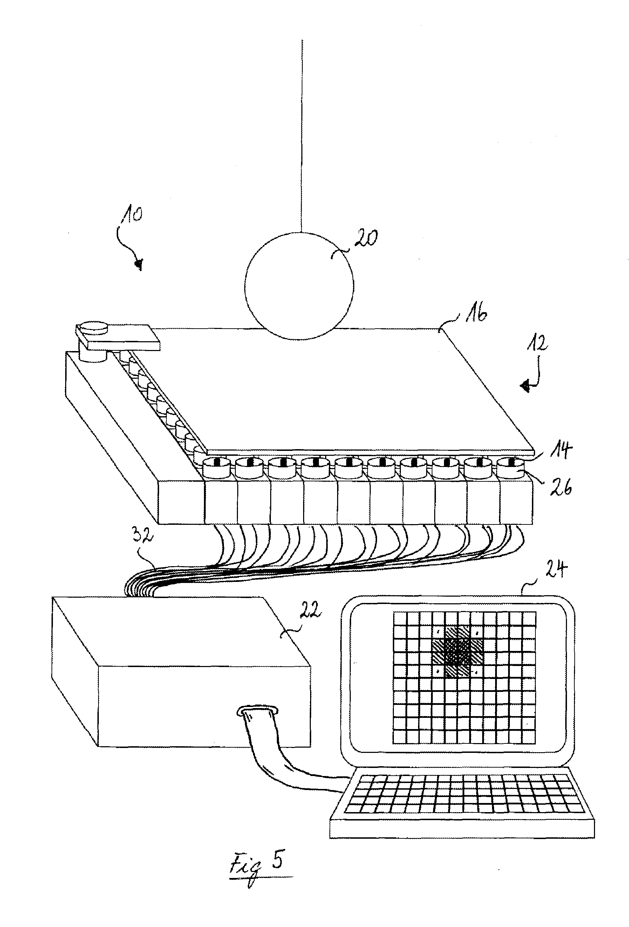

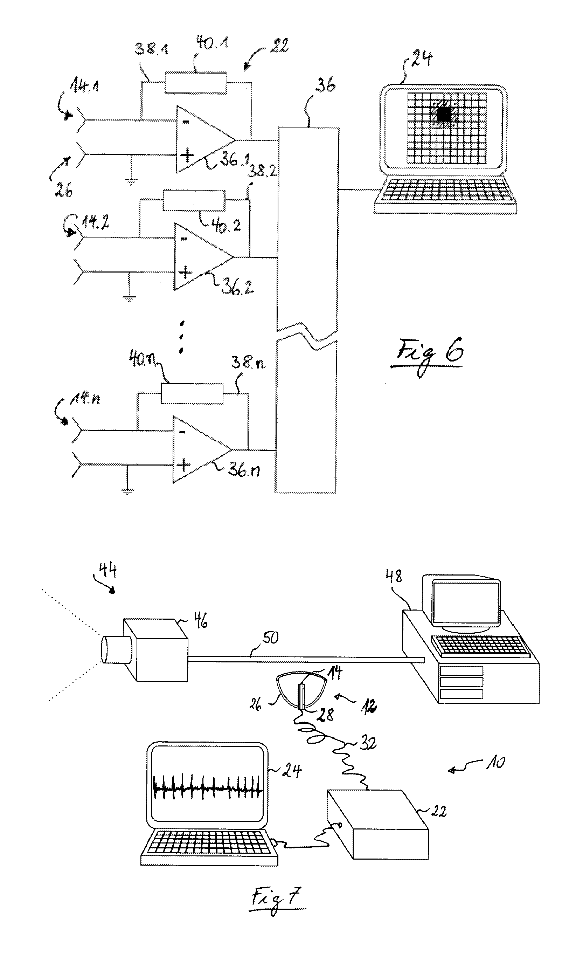

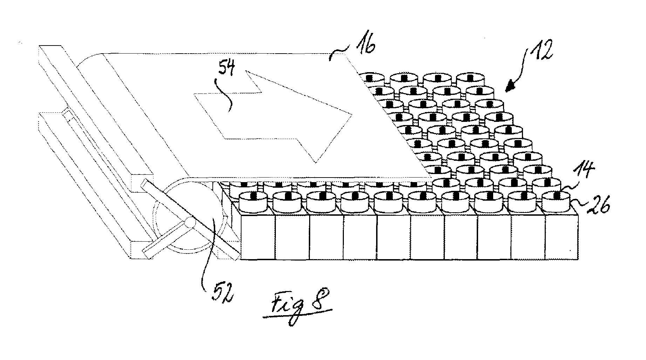

Fig. 4 and 5 show an experimental setup with an electrostatic sensor 10 adapted for spatially resolved detection of uncharged conductive objects. A metal body 20 is suspended from the ceiling and its movements are to be detected by the electrostatic sensor 10. The sensor head 12 comprises a 10x10 array of sensing electrodes 14. In the embodiment of the electrostatic sensor shown in Fig. 4, each sensing electrode 14 is covered with a charged electrically insulating tubular plastic screen. In the alternative embodiments of Fig. 5, a charged plane plastic screen 16, common to all the sensing electrodes 14, is arranged between the sensing electrodes and the object to be detected. The plastic screen 16 can be moved from its operational position in front of the sensing electrodes to an inactive position. In its inactive position, the plastic screen 16 is not arranged in front of the sensing electrodes. Switching between operational and inactive positions can be achieved by rotating the plastic screen 16 around an axis outside the matrix of the sensing electrodes 14. With the plastic screen 16 in its inactive position, the electrostatic sensor 10 can be used for detection of electrostatically charged objects. Grounded reference electrodes 26 are arranged laterally around the sensing electrodes 14. The sensing electrodes 14 are electrically connected to amplification circuits inside the amplification unit 22. The signals of sensing electrodes 14 are separately provided to the amplification unit by shielded cables 32 (not all of them shown in the figures) and amplified by an adjustable factor. The input impedance of the amplification circuits is extremely high (up to 10¹⁵ Ohms), so that virtually no current is drawn from the sensing electrodes 14. The amplified signals are provided to a multiplexer 42 (see Fig. 6), which produces a multiplexed output signal. The multiplexed output signal is provided to a computer 24, which analyses the received signals. Depending on the application, the computer can display an image of the received signal amplitudes, store the amplitudes in memory and/or identify certain patterns in the image.

The sensor head 12 may comprise an electric motor, which drives the plastic screen 16 from its operational to its inactive position. The plastic screen 16 can also be achieved as a curtain (see Fig. 8), which is rolled up on a cylinder 52 in its inactive position and which can be moved, manually or automatically, over the sensing electrodes 14 along the direction indicated by arrow 54. The plastic may be chosen such that the rolling off from the cylinder 52 creates the electrostatic charges on the plastic screen 16. An additional charging step could then be omitted.

For detecting the uncharged metal body 20, the sensor head 12 is in movement with respect to the metal body 20. The skilled person will appreciate that it can actually be the metal body 20 that moves while the sensor head 12 is at rest.

Electrostatic sensors like those of Figs. 4 and 5 can for instance be used for imaging the modes of a vibrating object, e.g. an engine. With its extremely high impedance, displacements of conductive structures can be remotely detected in the sub-micrometer range.

It shall further be noted that the electrostatic sensor matrix may be used for recording a spatially resolved electroencephalogram or electrocardiogram. A two-dimensional map of the brain or heart activity may thus be obtained.

In certain cases, it may prove useful if the sensing electrodes are arranged on a curved surface, for example on the inner side of a hood, which is put over a patient's head for taking an electroencephalogram at several points of the head. As the sensing electrodes need not being in contact with the patient's skin, there can be a spacing structure, which keeps them at a defined distance from the head. Air may thus circulate between the sensing electrodes and the head, which greatly enhances the patient's comfort during the measurement as sweating may for instance be reduced.

A simplified block diagram of the electrical circuits of an electrostatic sensor as in Figs. 4 and 5 is shown in Fig. 6. A plurality of passive sensing electrodes 14.1, 14.2, ..., 14.n (n being a positive integer) are connected to an amplification stage 22, which comprise at least one first low-noise operational amplifier 36.1, 36.2, ..., 36.n associated with each sensing electrode 14.1, 14.2, ..., 14.n. In certain embodiments, the output of the first low-noise operational amplifier is connected to an input of a second low-noise operational amplifier. It will be appreciated that the signals on the sensing electrodes 14.1, 14.2, ..., 14.n are amplified individually. The ultrahigh impedance of the amplification stage is achieved by the feedback loops 38.1, 38.2, ..., 38.n. The gain can be adjusted by changing the resistance 40.1, 40.2, ..., 40.n of the feedback loops 38.1, 38.2, ..., 38.n; preferably, the system comprises a switch or an automated system for adjusting the gain to an optimal value, depending on the amplitude of the sensed signal. After amplification, the signals are fed to a multiplexer 42, which preferably operates at a rate above 30 Hz, still more preferably between 50 to 100 Hz. Advantageously, the circuits comprise a filtering stage, which eliminates undesired frequency components, like for instance the 50-Hz- or 60-Hz-peak caused by mains. Such a filtering stage may be integrated into the multiplexer 42. The multiplexed signal is fed to a computer 24, which is equipped with an analog-to-digital converter and wherein the signal is demultiplexed. The individual signals of the sensing electrodes can thus be retrieved, analysed, displayed and/or stored in memory.

Fig. 7 illustrates the contactless detection of signals in a shielded communication cable. In a video surveillance system 44, a digital camera 46 is connected to an input port (e.g. RS 485 serial port) of a control computer 48 via a shielded communication cable 50. An electrostatic sensor 10 is provided for contactlessly eavesdropping the communication between the camera 46 and the control computer 48. The sensor head 12 is brought into proximity of the communication cable 50. The sensor head 12 may e.g. be a smaller version of the sensor head shown in Fig. 3 and will not be described in detail again. It shall be noted, however, that other sensor head configurations could also used for the present purpose. The sensor head 12 is connected to the high-impedance amplification stage 22, which feeds the amplified signals to the computer 24.

In the present case, the communication signal transmitted between the camera 46 and the control computer 48 is assumed to be of square-wave type. The signals measured by the electrostatic sensor 10, which are shown in an exemplary fashion on the screen of the computer 24, are usually not of square-wave type. The intervals between the detected electrostatic peaks correspond to those of the original communication signal. By convolution of the electrostatic signal with a square-wave function, it is possible to retrieve the original communication signal. The electrostatic sensor thus can detect the communication signals either emitted by the camera to the computer or vice versa.

The electrostatic sensor 10 can also be used to detect the electric signals inside an electronic appliance, e.g. a computer or a camera. For instance, if the sensor head 12 is brought into proximity of the camera 46, electric activity of the latter can remotely be detected. From the signal detected by the electrostatic sensor 10, one can draw certain conclusions, for instance, it is possible to determine the recording interval of the camera 46 or to eavesdrop on data exchanges inside the camera by using e.g. Fourier or wavelet analysis methods.

### List of Reference Numerals

- Electrostatic sensor: 10
- Sensor head: 12
- Sensing electrode: 14, 14.1, 14.2, ..., 14.n
- Plastic screen: 16
- Electrometer: 18
- Metal body: 20
- Amplification stage: 22
- Computer: 24
- Reference electrode: 26
- Insulating mounting: 28
- Patient's head: 30
- Shielded cable: 32
- Recorded data: 34
- Operational amplifier: 36.1, 36.2, ..., 36.n
- Feedback loop: 38.1, 38.2, ..., 38.n
- Resistance: 40.1, 40.2, ..., 40.n
- Multiplexer: 42
- Video surveillance system: 44
- Camera: 46
- Control computer: 48
- Communication cable: 50
- Cylinder: 52
- Arrow: 54

## Claims

1. An electrostatic sensor comprising:
a sensor head with at least one passive sensing electrode responsive to an electric field; and
a high-impedance amplification stage associated with said at least one sensing electrode, said high-impedance amplification stage for outputting at least one output signal in response to an electric signal induced on said at least one sensing electrode by said electric field;
**characterised in that**
said sensor head comprises a screen of electrically insulating material to be electrically charged in an operational mode of said electrostatic sensor, said screen being associated with said at least one sensing electrode.

2. An electrostatic sensor according to claim 1, comprising a grounded reference electrode connected to said amplification stage.

3. An electrostatic sensor according to claim 1 or 2, wherein said at least one sensing electrode comprises a stick electrode.

4. An electrostatic sensor according to claim 3, wherein said screen comprises a tubular screen arranged around said stick electrode.

5. An electrostatic sensor according to any one of the preceding claims, comprising a processing unit operationally connected to said amplification stage for analysing said electric field.

6. An electrostatic sensor according to any one of the preceding claims, wherein said charged layer is removably mounted on said sensor head.

7. An electrostatic sensor according to any one of the preceding claims, comprising a plurality of passive sensing electrodes arranged in a matrix, and wherein said amplification stage is configured so as to output a plurality of output signals, each one of these output signals being in response to an electric signal induced on a respective sensing electrode.

8. An electrostatic sensor according to claim 7, comprising a processing unit connected to said amplification stage for producing a 2D-image of said electric field.

9. Use of an electrostatic sensor according to any one of claims 1 to 8 for contactlessly sensing vibrations of an object.

10. Use of an electrostatic sensor according to any one of claims 1 to 8 for recording an electroencephalogram.

11. Use of an electrostatic sensor according to any one of claims 1 to 8 for recording an electrocardiogram.

12. Use of an electrostatic sensor according to any one of claims 1 to 8 for contactlessly detecting an electric signal in a cable.

13. Use of an electrostatic sensor according to any one of claims 1 to 8 for detecting an electrically uncharged conductive body, which is in movement with respect to said sensor head.

14. Method for detecting an electrically uncharged conductive body at rest in a target region, comprising the steps of:
providing an electrostatic sensor according to any one of claims 1 to 8;
moving said sensor head with respect to said target region;
sensing spatial variations of said electric field so as to locate said electrically uncharged conductive body.

15. Method for detecting an electrically uncharged conductive body moving in a target region, comprising the steps of:
providing an electrostatic sensor according to any one of claims 1 to 8;
keeping said sensor head at rest with respect to said target region;
sensing spatial variations of said electric field so as to locate said electrically uncharged conductive body.
